# EUROPEAN PATENT SPECIFICATION

(11) **EP 1 526 568 B1**
(45) Date of publication and mention of the grant of the patent: **25.02.2009**
(21) Application number: 03425687.5
(22) Date of filing: 22.10.2003
(51) Int. Cl.: H01L 21/8247, H01L 21/8234

(54) **Sealing method for electronic devices formed on a common semiconductor substrate**
Versiegelungsverfahren für auf einem gemeinsamen Substrat hergestellte elektronische Bauelemente
Procédé d'encapsulation pour dispositifs électroniques formés dans un meme substrat semiconducteur

(43) Date of publication of application: 27.04.2005
(73) Proprietor: STMicroelectronics S.r.l., 20041 Agrate Brianza (Milano) (IT)
(72) Inventor: Camerlenghi, Emilio, 24128 Bergamo (IT); Maurelli, Alfonso, 20050 Sulbiate (Milano) (IT); Peschiaroli, Daniela, 20131 Milano (IT); Zabberoni, Paola, 20052 Monza (Milano) (IT)
(74) Representative: Niederkofler, Oswald

(56) References cited:
- US-A1- 2003 151 069
- US-B1- 6 468 867
- US-B1- 6 630 378
- PATENT ABSTRACTS OF JAPAN vol. 1996, no. 10, 31 October 1996 (1996-10-31) -& JP 08 153860 A (MITSUBISHI ELECTRIC CORP), 11 June 1996 (1996-06-11)

## Description

### Field of application

The present invention relates to a sealing method for electronic devices formed on a common semiconductor substrate.

More specifically, the invention relates to a sealing method for electronic devices formed on a common semiconductor substrate comprising the steps of:
- forming at least a first conductive layer on a first semiconductor substrate portion,
- forming a second conductive layer on a second semiconductor substrate portion.

The invention particularly relates, but not exclusively, to a differential sealing method of non volatile memory cells with double polysilicon level and transistors, associated thereto, formed on a common semiconductor substrate and the following description is made with reference to this field of application for convenience of illustration only.

### Prior art

As it is well known, the integration on a common semiconductor substrate of different electronic devices, such as for example traditional transistors and non volatile memory cells with double polysilicon level, has always posed the problem of reconciling the possible different needs of "sealing" these two different types of electronic devices. Sealing means that manufacturing process step wherein one or more layers are formed after defining the polysilicon layer realising the gate region of transistors and memory cells, and that, in practise, seals these electronic devices.

Typically, memory cells undergo a high quality sealing step, to ensure the retention properties of the charge stored in the floating gate region, while in the transistor case the only requirement for this sealing step is a protection layer from the subsequent process steps.

A prior art solution to meet this requirement provides the use of two different photolithographic masks to define first the gate regions in a memory matrix and then those of the circuitry (even if the order is not significant) and afterwards the simultaneous oxidation of both the electronic devices so-defined occurs, thus sealing the devices by means of a single sealing layer.

Although advantageous under several aspects, this solution has several drawbacks as the electronic device size decreases.

In fact, the continuous reduction of the electronic device size pushes transistors to require thinner and thinner sealing layers (and possibly heat treatments with lower and lower temperatures), while memory cells keep on needing thicker layers, besides higher quality requirements.

Another prior art solution is disclosed in the US application patent No. US-A1-2003151069 of Sugimae et al. published on August 14, 2003, which relates to a method for manufacturing a semiconductor memory device comprising a step of forming first and second insulating films for the peripheral and memory portions of the device. These films are formed after the definition of the gates of the transistors comprised into said portions.

Also known from the US patent No. US-B 1-6468867 of Lai et al. issued on October 22, 2002 is a method for forming a salicide layer in a partial region of a memory device.

The technical problem underlying the present invention is to provide an independent sealing method for electronic devices formed on a common semiconductor substrate, having such structural features as not to jeopardise the individually optimised performances and reliability of these devices and not to require further steps or masks in addition to the traditional process flow, overcoming the limits and drawbacks still affecting prior art methods.

### Summary of the invention

The solution idea underlying the present invention is to form, on a common semiconductor substrate, devices provided with sealing layers of different thickness, these sealing layers being realised immediately after defining the single devices.

On the basis of this solution idea the technical problem is solved by a method as previously indicated and defined in claim 1.

The features and advantages of the method according to the invention will be apparent from the following description of an embodiment thereof given by way of non-limiting example with reference to the attached drawings.

### Brief description of the drawings

In the drawings:

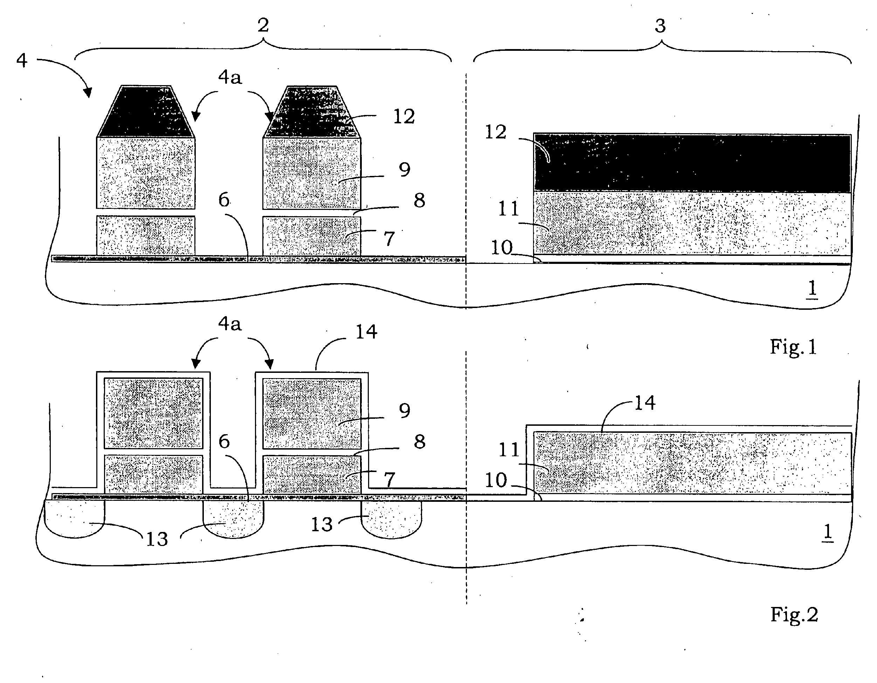

- Figures 1 to 4 are respective vertical-section enlarged-scale views of different portions of a semiconductor substrate in the development of a manufacturing method according to the invention.

### Detailed description

With reference to these figures, a method for sealing electronic devices formed on a common semiconductor substrate in an independent manner and the corresponding circuit structure are described.

The method steps described hereafter do not form a complete process flow for manufacturing integrated circuits. The present invention can be implemented together with the integrated circuit manufacturing techniques presently used in this field and only those commonly used process steps which are necessary to understand the present invention are comprised in the description.

The figures representing cross sections of portions of a circuit structure during the manufacturing are not drawn to scale, but they are drawn instead in order to show the important features of the invention.

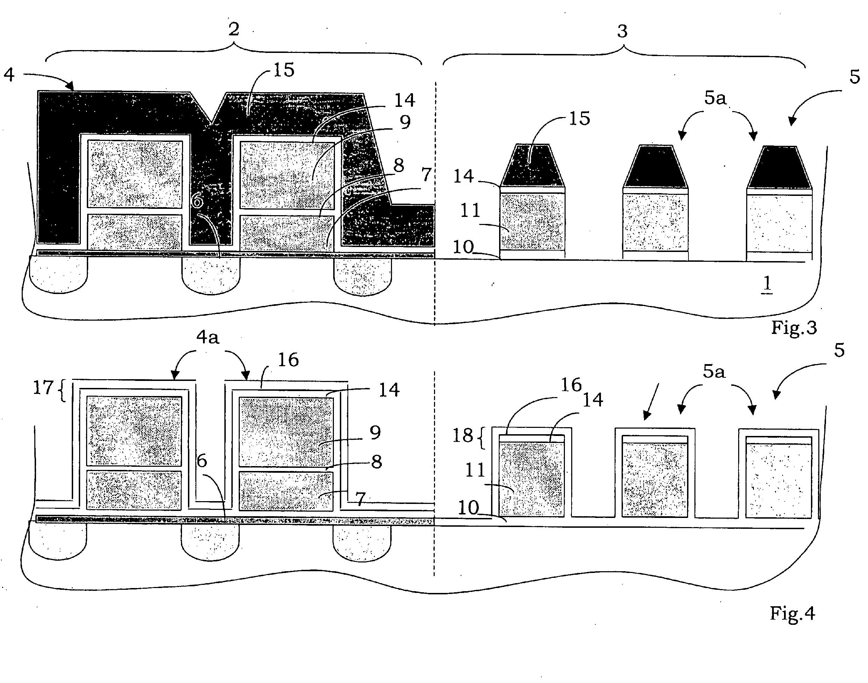

With reference to figure 4 a circuit structure integrated on a semiconductor substrate 1 is shown, comprising a first plurality of electronic devices 4, for example non volatile memory cells. Each of these electronic devices 4 comprises a region 4a projecting from the semiconductor substrate 1, formed for example by one or more conductive layers 7, 9 being electrically insulated from each other by means of an insulating layer 8. The region 4a is coated with a first sealing structure 17 of a first thickness performing the sealing of these electronic devices 4.

Advantageously, this first sealing structure 17 comprises a plurality of insulating layers 14, 16.

Moreover, advantageously, the first sealing structure 17 also covers a portion of the exposed semiconductor substrate 1 between the single electronic devices 4.

The semiconductor substrate 1 also comprises a second plurality of electronic devices 5, for example traditional transistors. Each of these electronic devices 5 comprises a region 5a projecting from the semiconductor substrate 1, formed for example by at least one conductive layer 11. The region 5a is coated with a second sealing structure 18 performing the sealing of these electronic devices 5. Advantageously, the second sealing structure 18 has a lower thickness, on the semiconductor substrate 1, than the thickness of the first sealing structure 17 covering the electronic devices 4.

Moreover, advantageously, the second sealing structure 18 has a lower thickness on the vertical walls of the region 5a, while it has a higher thickness on the top of this region 5a. It is thus possible to realise very close electronic devices 5 allowing a higher integration scale.

Advantageously, the second sealing structure 18 comprises at least an insulating structure 16.

The manufacturing method of a circuit structure according to the invention is now described.

In particular, by way of example, a method for integrating non volatile flash memory cells with transistors realised in the CMOS technology is described hereafter.

A matrix 2 of cells with associated control circuitry 3 is realised on a semiconductor substrate 1, the cell matrix 2 comprising a plurality of non volatile memory cells 2, while the control circuitry 3 comprises a plurality of transistors 5.

As it is well known, a manufacturing process of the cell matrix 2 provides the formation, on the semiconductor substrate 1 in cascade, of a first insulating layer 6, for example silicon oxide, a first conductive layer 7, for example polysilicon, a second insulating layer 8, for example silicon oxide, and a second conductive layer 9, for example polysilicon. The formation of a third insulating layer 10, for example silicon oxide, and a third conductive layer 11, for example polysilicon, is instead provided to realise the circuitry.

Advantageously, the third conductive layer 11 is realised simultaneously with the second conductive layer 9.

Still advantageously, the third insulating layer 10 is realised simultaneously with the second insulating layer 8.

A first photoresist material layer 12 is then deposited on the whole semiconductor substrate 1.

By using a traditional photolithographic technique, the first photoresist layer 12 is etched to define a plurality of gate regions 4a of the memory cells 4, while a portion of this first photoresist material layer 12 in the circuitry 3 is left to screen the third conductive layer 11, as shown in figure 1.

Being the definition of the gate regions 4a of the memory cells 4 completed through a etching step of the second conductive layer 9, of the second insulating layer 8 and of the first conductive layer 7, in cascade, the first photoresist material layer 12 is then removed and implants are carried out to realise, in a traditional way, source and drain regions 13 of the memory cell 4.

Advantageously, these implants are optimised to improve the memory cell 4 performances.

According to the invention, memory cells 4 are then sealed forming a first insulating or sealing layer 14, for example through a high-temperature fast oxidation step.

Advantageously, the first sealing layer 14 is 3-7 nm thick, for example about 4 nm.

The so-formed sealing layer 14 coats not only the gate regions 4a of memory cells 4, but it also covers a portion of the semiconductor substrate 1 being left exposed in the matrix 2, and the third conductive layer 11 not yet defined in the circuitry 3, as shown in figure 2.

A second photoresist material layer 15 is then deposited on the whole semiconductor substrate 1.

By using a traditional photolithographic technique, this second photoresist layer 15 is then etched to define a plurality of gate regions 5a of transistors 5, while a portion of this second photoresist material layer 15 on the matrix 2 is left to screen the memory cells 4 of the matrix 2, as shown in figure 3.

In particular, the circuitry portions being uncovered by the photoresist layer 15 undergo first an etching step to remove the first sealing layer 14 and then an etching step to remove the conductive layer 11.

Being the photoresist layer 15 removed, transistors 5 are sealed by forming a second thin insulating or sealing layer 16, for example through an oxidation step.

Advantageously, the thickness of this second thin sealing layer 16 is between 1 and 3 nm, for example 2 nm.

Advantageously, this second thin sealing layer 16 completely covers the first sealing layer 14.

Therefore, according to the invention, a first sealing structure 17 is thus formed, comprising the first sealing layer 14 and the second sealing layer 16, which completely coats the gate regions 4a of memory cells 4 to perform the sealing step thereof.

Moreover, a second sealing structure 18 is formed, which completely coats the gate regions 5a of transistors 5 to seal them, this second sealing structure 18 comprising the second sealing layer 16 and portions of the first sealing layer 14 which are on the upper portion of the gate regions 5a of transistors 5.

Moreover, it is worth noting that the definition step of the gate regions 5a of transistors 5, performed after the deposition step of the first sealing layer 14, realises projecting regions having portions of that sealing layer 14 on the top thereof, but not on the side walls thereof.

Advantageously, according to the invention, the formation of this second thin sealing layer 16 does not affect the electric capacities of cells 4, both because the source and drain regions 13 in the matrix 2 have already been formed, and because the heat treatments involved in the formation of this second thin sealing layer 16 are performed at lower temperatures than the temperatures undergone by the cells 4 for the specific sealing thereof.

The manufacturing method according to the invention is completed according to the prior art.

With the method according to the invention, both traditional memory cells 4 and traditional transistors 5 can be successfully integrated on the common semiconductor substrate 1, penalising neither the performances nor the reliability, with the following differences with respect to prior art methods:
- each definition of the projecting 4a and gate 5a regions, first in the matrix 2 and then in the circuitry 3, is followed by a respective sealing step which is optimised by using sealing layers 14, 16 of different thickness and/or materials;
- the etching step of the conductive layer 11 of the circuitry 3 to define gate regions 5a provides the following steps:
   - removing the first sealing layer 14 formed also on the conductive layer 11 of the circuit 3,
   - traditionally etching the conductive layer 11 through a highly selective etching step towards the insulating layer 10.

In an alternative embodiment of the method according to the invention immediately after sealing memory cells 4, an additional mask is used to leave only the circuitry 3 exposed.

The sealing layer 14 is then removed from the conductive layer 11, before defining real gate regions 5a in the circuitry 3.

In this embodiment of the method according to the invention, the second sealing structure 18 sealing the gate regions 5a of transistors 5 is only formed by the second sealing layer 16.

This alternative embodiment is advantageously applied when the materials used to form the sealing layer 14 for sealing memory cells 4 are different from thermal oxide and must be necessarily removed to allow the conductive layer 11 to be correctly etched to define gate regions 5a in the circuitry 3.

In conclusion, the method according to the invention allows typologies of electronic devices requiring different types of sealing to be integrated without jeopardising the individually optimised performances and reliability for each device, with low or no cost.

After all, according to the invention, the sealing step of these electronic devices is achieved by means of sealing layers with different thickness, and, in case, also comprising materials being formed immediately after defining the devices of the matrix 2 and of the circuitry 3.

## Claims

1. A method of sealing electronic devices (4, 5) formed on a common semiconductor substrate (1) comprising the steps of:
- forming at least a first conductive layer (7, 9) on a first portion (2) of said semiconductor substrate (1),
forming a second conductive layer (11) on a second portion (3) of said semiconductor substrate (1), said method comprising the following further steps in sequence:
- defining a first plurality of regions (4a) of said electronic devices (4) in said at least one first conductive layer (7, 9),
- forming a first sealing layer (14) on the whole semiconductor substrate (1) to seal said first plurality of regions (4a),
- defining a second plurality of regions (5a) of said electronic devices (5) in said second conductive layer (11),
- forming a second sealing layer (16) on the whole semiconductor substrate (1) to seal said second plurality of regions (5a).

2. A sealing method for electronic devices (4, 5) according to claim 1, **characterised in that** the second sealing layer (16) has a lower thickness than the thickness of the first sealing layer (14).

3. A sealing method for electronic devices (4, 5) according to claim 1, **characterised in that** it comprises a removal step of said first sealing layer (14) from said second conductive layer (11) before defining said second plurality of regions (5a).

4. A sealing method for electronic devices (4, 5) according to claim 1, **characterised in that** said definition step of said first plurality of regions (4a) comprises the steps of:
- depositing a first photoresist material layer (12) on the whole of said semiconductor substrate (1),
- photolithographically patterning said photoresist material layer (12) by etching to leave it on said second conductive layer (11) in said second portion (3) of said semiconductor substrate (1) and on areas corresponding to said first plurality of regions (4a),
- etching said first conductive layer (7, 9) in said first portion (2) of said semiconductor substrate (1) using said photoresist material layer (12) as a mask in order to define said first plurality of regions (4a); and
- removing said photoresist material layer (12).

5. A sealing method for electronic devices (4, 5) according to claim 1, **characterised in that** the definition step of said second plurality of regions (5a) comprises the steps of:
- depositing a second photoresist material layer (15) on said semiconductor substrate (1),
- photolithographically patterning said second photoresist material layer (15) by etching to leave it on areas corresponding to said second plurality of regions (5a) of said first conductive layer (7, 9) in said first portion (2) of said semiconductor substrate (1),
- etching said first sealing layer (14) and said second conductive layer (11) in said second portion of said semiconductor substrate (1) using said second photoresist material layer (15) as a mask in order to define said second plurality of regions (5a), and
- removing said second photoresist material layer (15).

6. A sealing method for electronic devices (4, 5) according to claim 1, **characterised in that** a third conductive layer (9) is formed on said first conductive layer before defining said first plurality of regions (4a).

7. A sealing method for electronic devices (4, 5) according to claim 6, **characterised in that** the formation step of said third conductive layer (9) is realised simultaneously with the second conductive layer.

## Patentansprüche

1. Verfahren zum Versiegeln elektronischer Bauteile (4, 5), die auf einem gemeinsamen Halbleitersubstrat (1) gebildet sind, umfassend:
- Bilden wenigstens einer ersten leitenden Schicht (7, 9) auf einem ersten Bereich (2) des Halbleitersubstrats (1),
- Bilden einer zweiten leitenden Schicht (11) auf einem zweiten Bereich (3) des Halbleitersubstrats (1), wobei das Verfahren der Reihe nach umfasst:
- Definieren einer ersten Mehrzahl von Gebieten (4a) der elektronischen Bauteile (4) in der wenigstens einen ersten leitenden Schicht (7, 9),
- Bilden einer ersten Siegelschicht (14) auf dem gesamten Halbleitersubstrat (1), um die erste Mehrzahl von Gebieten (4a) zu versiegeln,
- Definieren einer zweiten Mehrzahl von Gebieten (5a) der elektronischen Bauteile (5) in der zweiten leitenden Schicht (11),
- Bilden einer zweiten Siegelschicht (16) auf dem gesamten Halbleitersubstrat (1), um die zweite Mehrzahl von Gebieten (5a) zu versiegeln.

2. Versiegelungsverfahren für elektronische Bauteile (4, 5) nach Anspruch 1, **dadurch gekennzeichnet, dass** die zweite Siegelschicht (16) eine Dicke aufweist, die geringer ist als die Dicke der ersten Siegelschicht (14).

3. Versiegelungsverfahren für elektronische Bauteile (4, 5) nach Anspruch 1, umfassend Entfernen der ersten Siegelschicht (14) von der zweiten leitenden Schicht (11), bevor die zweite Mehrzahl von Gebieten (5a) definiert wird.

4. Versiegelungsverfahren für elektronische Bauteile (4, 5) nach Anspruch 1, **dadurch gekennzeichnet, dass** das Definieren der ersten Mehrzahl von Gebieten (4a) umfasst:
- Auftragen einer ersten Photolackmaterialschicht (12) auf dem gesamten Halbleitersubstrat (1),
- photolithographisches Strukturieren der Photolackmaterialschicht (12) durch Ätzen, um sie auf der zweiten leitenden Schicht (11) im zweiten Bereich (3) des Halbleitersubstrats (1) und auf Flächen zu hinterlassen, die der ersten Mehrzahl von Gebieten (4a) entsprechen,
- Ätzen der ersten leitenden Schicht (7, 9) in dem ersten Bereich (2) des Halbleitersubstrats (1), wobei die Photolackmaterialschicht (12) als Maske verwendet wird, um die erste Mehrzahl von Gebieten (4a) zu definieren; und
- Entfernen der Photolackmaterialschicht (12).

5. Versiegelungsverfahren für elektronische Bauteile (4, 5) nach Anspruch 1, **dadurch gekennzeichnet, dass** das Definieren der zweiten Mehrzahl von Gebieten (5a) umfasst:
- Auftragen einer zweiten Photolackmaterialschicht (15) auf dem Halbleitersubstrat (1),
- photolithographisches Strukturieren der zweiten Photolackmaterialschicht (15) durch Ätzen, um Flächen zu hinterlassen, die der zweiten Mehrzahl von Gebieten (5a) der ersten leitenden Schicht (7, 9) in dem ersten Bereich (2) des Halbleitersubstrats (1) entsprechen,
- Ätzen der ersten Siegelschicht (14) und der zweiten leitenden Schicht (11) in dem zweiten Bereich des Halbleitersubstrats (1), wobei die zweite Photolackmaterialschicht (15) als Maske verwendet wird, um die zweite Mehrzahl von Gebieten (5a) zu definieren, und
- Entfernen der zweiten Photolackmaterialschicht (15).

6. Versiegelungsverfahren für elektronische Bauteile (4, 5) nach Anspruch 1, **dadurch gekennzeichnet, dass** eine dritte leitende Schicht (9) auf der ersten leitenden Schicht gebildet wird, bevor die erste Mehrzahl von Gebieten (4a) definiert wird.

7. Versiegelungsverfahren für elektronische Bauteile (4, 5) nach Anspruch 6, **dadurch gekennzeichnet, dass** das Bilden der dritten leitenden Schicht (9) gleichzeitig mit der zweiten leitenden Schicht verwirklicht wird.

## Revendications

1. Méthode d'encapsulation de dispositifs électroniques (4, 5) formés sur un substrat semi-conducteur commun (1) comprenant les étapes consistant à :
■ former au moins une première couche conductrice (7, 9) sur une première partie (2) dudit substrat semi-conducteur (1),
■ former une deuxième couche conductrice (11) sur une seconde partie (3) dudit substrat semi-conducteur (1), ledit procédé comprenant les étapes supplémentaires suivantes en séquence :
■ définir une première pluralité de régions (4a) desdits dispositifs électroniques (4) dans ladite au moins une première couche conductrice (7, 9),
■ former une première couche d'encapsulation (14) ■ sur le substrat semi-conducteur entier (1) pour encapsuler ladite première pluralité de régions (4a),
■ définir une seconde pluralité de régions (5a) desdits dispositifs électroniques (5) dans ladite deuxième couche conductrice (11),
■ former une seconde couche d'encapsulation (16) sur le substrat semi-conducteur entier (1) pour encapsuler ladite seconde pluralité de régions (5a).

2. Méthode d'encapsulation pour des dispositifs électroniques (4, 5) selon la revendication 1, **caractérisée en ce que** la seconde couche d'encapsulation (16) possède une épaisseur inférieure à l'épaisseur de la première couche d'encapsulation (14).

3. Méthode d'encapsulation pour des dispositifs électroniques (4, 5) selon la revendication 1, **caractérisée en ce qu'**elle comprend une étape d'élimination complète de ladite première couche d'encapsulation (14) à partir de ladite deuxième couche conductrice (11) avant de définir ladite seconde pluralité de régions (5a).

4. Méthode d'encapsulation pour des dispositifs électroniques (4, 5) selon la revendication 1, **caractérisée en ce que** ladite étape de définition de ladite première pluralité de régions (4a) comprend les étapes consistant à :
■ déposer une première couche de matériau photorésistant (12) sur la totalité dudit substrat semi-conducteur (1),
■ configurer de façon photolithographique ladite couche de matériau photorésistant (12) par gravure pour la laisser sur ladite deuxième couche conductrice (11) dans ladite seconde partie (3) dudit substrat semi-conducteur (1), et sur des zones correspondant à ladite première pluralité de régions (4a),
■ graver ladite première couche conductrice (7, 9) dans ladite première partie (2) dudit substrat semi-conducteur (1) en utilisant ladite couche de matériau photorésistant (12) en tant que masque afin de définir ladite première pluralité de régions (4a) ; et
■ éliminer ladite couche de matériau photorésistant (12).

5. Méthode d'encapsulation pour des dispositifs électroniques (4, 5) selon la revendication 1, **caractérisée en ce que** l'étape de définition de ladite seconde pluralité de régions (5a) comprend les étapes consistant à :
■ déposer une seconde couche de matériau photorésistant (15) sur ledit substrat semi-conducteur (1),
■ configurer de façon photolithographique ladite seconde couche de matériau photorésistant (15) par gravure pour la laisser sur des zones correspondant à ladite seconde pluralité de régions (5a) de ladite première couche conductrice (7, 9) dans ladite première partie (2) dudit substrat semi-conducteur (1),
■ graver ladite première couche d'encapsulation (14) et ladite deuxième couche conductrice (11) dans ladite seconde partie dudit substrat semi-conducteur (1) en utilisant ladite seconde couche de matériau photorésistant (15) en tant que masque afin de définir ladite seconde pluralité de régions (5a) ; et
■ éliminer ladite seconde couche de matériau photorésistant (15).

6. Méthode d'encapsulation pour des dispositifs électroniques (4, 5) selon la revendication 1, **caractérisée en ce qu'**une troisième couche conductrice (9) est formée sur ladite première couche conductrice avant de définir ladite première pluralité de régions (4a).

7. Méthode d'encapsulation pour des dispositifs électroniques (4, 5) selon la revendication 6, **caractérisée en ce que** l'étape de formation de ladite troisième couche conductrice (9) est réalisée simultanément à la seconde deuxième couche conductrice.
